# EUROPEAN PATENT APPLICATION

(11) **EP 4 238 807 A1**
(43) Date of publication of application: **06.09.2023**
(21) Application number: 22159366.8
(22) Date of filing: 01.03.2022
(51) Int. Cl.: B60L 3/00, B60L 53/14, B60L 53/66, B60L 53/68, G01R 31/00, H02J 7/00

(54) **ELECTRO VEHICLE CHARGING INFRASTRUCTURE**

(71) Applicant: Siemens Schweiz AG, 8047 Zürich (CH)
(72) Inventor: Geelen, Ruud, 8053 Zürich (CH)

(57) **Abstract**

A system and a method for checking conditions of an electric vehicle (EV) at an EV charge point, wherein at the EV charge point vehicle data are pulled out of the electrical vehicle (EV) via a suitable interface; wherein the vehicle data are communicated via a communication link from the EV charge point to a server computer; wherein the vehicle data are analyzed by the server computer by using data analytics methods to evaluate conditions of the electric vehicle (EV) or of critical components (e.g. conduct system) of the electric vehicle (EV) during the charging process for the electric vehicle (EV).

## Description

### FIELD OF THE INVENTION

The present invention relates generally to the technical field of charging and servicing electric vehicles.

### BACKGROUND

Internal Combustion Engine (ICE) vehicles will be replaced by Electric Vehicles (EV) over the coming years. The purchase and use of Electric Vehicles (EV) is poised to rapidly expand worldwide in the near term. The charging of Electric Vehicles (EV) is accomplished at EV charge points located at the owner's residence or at external 3^{rd} party EV charging stations.

### SUMMARY OF THE INVENTION

The object of the invention is to provide EV charge points which perform a service check on the electric vehicles (EV) at the same time as the battery charging process.

A first aspect of the invention is a system for managing electric vehicle (EV) charging and servicing, the system comprising:
an EV charge point (e.g. EV charging station, wall box) in communication with a server computer and a database, the EV charge point comprising:
   an output to supply electric charging power to an electric vehicle, the electric charging power being provided by an electricity supply unit (e.g. battery, generator, energy provider);
   an interface to get vehicle data out of the electrical vehicle;
   a communication link (e.g. radio, IP-communication) to communicate the vehicle data to the server computer;
   a server computer configured to receive the vehicle data, wherein the server computer is further configured to carry out automated inspections by applying advanced automatic data analytics to the vehicle data to evaluate conditions of the electric vehicle or of critical components (e.g. conduct system, battery of EV) of the electric vehicle during the charging process for the electric vehicle.

A second aspect of the invention is an electrical vehicle charge point (e.g. EV charging station, wall box) in communication with a server computer and a database, the EV charge point comprising:
an output to supply electric charging power to an electric vehicle, the electric charging power being provided by an electricity supply unit (e.g. battery at charge point, energy provider);
an interface to get vehicle data out of the electrical vehicle;
a communication link (e.g. radio, IP-communication, etc) to communicate the vehicle data to a server computer;
wherein the EV charge point is configured to receive data about findings of the data analytics to the respective vehicle data from the server computer;
wherein the EV charge point comprises a display to view text information and/or graphics about the findings of the data analytics to the respective vehicle data.

A third aspect of the invention is a method for checking conditions of an electric vehicle (EV) at an EV charge point, the method comprising:
(ST1) providing an interface for the EV charge point (EVCP) to get vehicle data out of the electrical vehicle at the EV charge point;
(ST2) providing a communication link between the EV charge point and a server computer;
(ST3) communicating the vehicle data to the server computer;
(ST4) analyzing the vehicle data by the server computer by using data analytics methods to evaluate conditions of the electric vehicle or of critical components (e.g. conduct system, battery) of the electric vehicle during the charging process for the electric vehicle.

### BRIEF DESCRIPTION OF THE DRAWINGS

The above-mentioned and other concepts of the present invention will now be addressed with reference to the drawings of the preferred embodiments of the present invention. The shown embodiments are intended to illustrate, but not to limit the invention. The drawings contain the following figures, in which like numbers refer to like parts throughout the description and drawings and wherein:
- FIG 1: illustrates a first exemplary system for managing electric vehicle (EV) charging and servicing at an EV charge point,
- FIG 2: illustrates a second exemplary system for managing electric vehicle (EV) charging and servicing at an EV charge point, and
- FIG 3: illustrates an exemplary flowchart of a method for checking conditions of an electric vehicle (EV) at an EV charge point.

### DETAILED DESCRIPTION

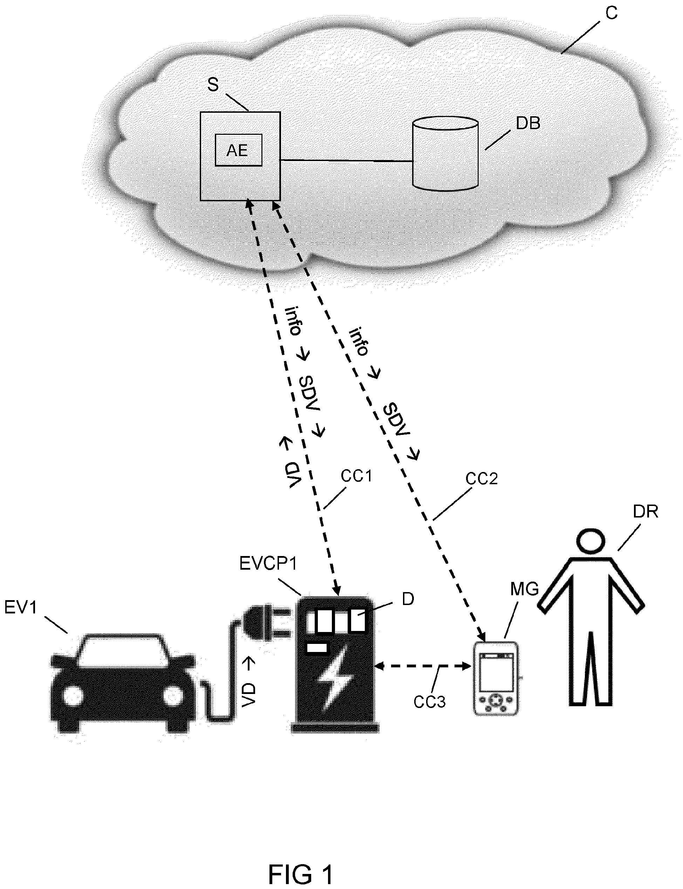

Figure 1 illustrates a first exemplary system for managing electric vehicle EV1 charging and servicing at an EV charge point EVPC1, the system comprising:
an EV charge point EVPC1 in communication with a server computer S and a database DB, the EV charge point (EVCP1) comprising:
   an output to supply electric charging power to an electric vehicle EV1, the electric charging power being provided by an electricity supply unit (e.g. an energy provider);
   an interface to get vehicle data VD out of the electrical vehicle EV1;
   a communication link CC1 (e.g. radio, IP-communication) to communicate the vehicle data VD to the server computer S;
   a server computer S configured to receive the vehicle data VD, wherein the server computer S is further configured to carry out automated inspections by applying data analytics methods to the vehicle data VD to evaluate conditions of the electric vehicle EV1 or of critical components (e.g. conduct system, battery) of the electric vehicle EV1 during the charging process for the electric vehicle EV1.

Advantageously the automated inspections and the evaluation of the conditions of the electric vehicle EV1 or of critical components of the electric vehicle EV1 are performed simultaneously or in parallel during the charging process for the electric vehicle EV1.

The server computer S comprises an analytics Engine AE to perform data analytics methods (AI, Artificial Intelligence algorithms) and/or automated inspections to the vehicle data VD to evaluate conditions of the electric vehicle EV1 and/or of critical components (e.g. conduct system, battery, electricity) of the electric vehicle EV1. The server computer S comprises suitable Hardware, Software and communication means to receive the vehicle data VD, to analyze the vehicle data VD and to provide the results or findings of the analysis of the vehicle data VD for the EV charge point EVCP1 and/or for a mobile communication device MG (e.g. smartphone) of the driver DR of the electric vehicle EV1. Advantageously the EV manufactures provide the data analytics algorithms and/or test data to carry out automated inspections for the respective electric vehicles EV1.

The vehicle data VD comprise data or a subset of data of the critical components of the electric vehicle EV1: e.g. conduct system, battery (traction battery), electric motor, power electronics, cooling systems, temperature management, heating/air conditioning system, battery management system, thermal management system of battery, powertrain, drive.

Advantageously the vehicle data VD comprise data recorded in a storage medium of the electric vehicle EV1 since the last service date (e.g. last maintenance or service check in a service station (e.g. garage)).

The vehicle data VD especially comprise data gained during the current charging process. E.g. the respective charging currents, respective charging voltage, respective temperature curves of the battery cells recorded over the entire charging process.

Advantageously during the charging process each battery cell is monitored and the vehicle data VD comprise voltage, currents and temperatures of the cells.

Advantageously during the charging process the temperature of the battery cells, the charging current or currents and the respective charging voltages are monitored to gain vehicle data VD. Since the battery must be cooled during charging, the associated fan should also be monitored to gain vehicle data VD.

The charging voltage could be monitored for small voltage dips when one of the cells connected in series shorts out. The same if the charging resistance suddenly increases, i.e. the charging voltage has to rise abruptly to restore the charging current. If the resistance increases excessively during charging, this may indicate damage inside the battery.

The analytics engine AE of the server computer S can be a rule based engine configured to execute discrete logic or algorithms. The analytics engine AE could also be a machine learning system comprising suitable neuronal networks.

Advantageously the analytics engine AE has access to suitable historical data, stored e.g. in a database DB, to perform the checks or inspections based on the vehicle data VD.

The information info provided by the analytics engine AE of the server computer S can be for instance, notes or hints on upcoming maintenance/service dates.

The Service Data Vehicle SDV provided by the analytics engine AE of the server computer S can be for instance, power density, energy density, or cycle stability. The Service Data Vehicle SDV can be provided as text and/or as graphical diagrams.

Advantageously the server computer S, the analytics engine AE, and the database DB are realized in a cloud infrastructure C. The cloud infrastructure C comprises suitable processor means, analytics means AE, memory means DB, and communication means CC1, CC2.

The communication link CC1 to communicate the vehicle data VD to the server computer S can be for instance, a wireless radio connection, an IP-communication connection, a LAN connection, or a Wide Area Network connection.

Advantageously the Service Data Vehicle SDV and the information info are provided from the server computer S to an output device (e.g. display D) of the EV charge point EVPC1 via the communication link CC1.

Advantageously the Service Data Vehicle SDV and the information info are also provided from the server computer S to a mobile communication device MG (e.g. a smartphone) of the driver DR of the electrical vehicle EV1 via the communication link CC2. The communication link CC2 can be a suitable mobile radio connection (e.g. cellular or mobile network).

Advantageously the server computer S has access to data regarding the electrical vehicle EV1 (e.g. historical maintenance data, identification data of the owner/driver, mobile phone number of a mobile communication device MG of the owner/driver) .

It is also possible that the EV charge point EVPC1 communicates with the mobile communication device MG of the owner/driver DR via a near field communication connection CC3 (e.g. Bluetooth Pairing). The Service Data Vehicle SDV and the information info can also be provided from the EV charge point EVPC1 via the near field communication connection CC3 the mobile communication device MG of the owner/driver DR.

The EV charge point EVPC1 can be located at the owner's DR residence (e.g. wall box) or at external 3^{rd} party EV charging stations.

An advantageous embodiment is that the communication link CC1 is configured to communicate data related to the EV charge point EVCP1 to the server computer S; and that the server computer S is further configured to receive the data related to the EV charge point EVCP1, wherein the server computer S is configured to carry out automated inspections in view of the status of the EV charge point EVCP1 by applying advanced automatic data analytics to the data related to the EV charge point EVCP1.

An advantageous embodiment is that the server computer S is part or is integrated in a Service Data Analytics Platform, especially an Ecosystem Service Data Analytics Platform, the Service Data Analytics Platform EV providing analysis services to a plurality of EV charge points EVCP1 and/or to a plurality of electric vehicles EV1. The analysis services can be provided as Software as a Service (SaaS). Each user subscribed at the Service Data Analytics Platform can use the analytics services.

By participating in an Ecosystem Service Data Analytics Platform, companies can create superior value in the form of products or services with their cooperation partners and/ customers. Furthermore, ecosystems enable companies or stakeholders to enter new markets or to gain competitive advantages over traditional competitors in markets they already represent. Ecosystem Service Data Analytics Platform for EV charge points EVCP1 and/or for electric vehicles EV1 can increase the satisfaction of the customers DR and therefore increase the loyalty of the customers DR.

An advantageous embodiment is that the server computer S is configured to inform the respective owners DR of the electrical vehicles EV1 about findings of the data analytics to the respective vehicle data VD of the respective electrical vehicle EV1. Advantageously the findings comprise information regarding predictive maintenance in view of components of the respective electrical vehicle EV1.

An advantageous embodiment is that the server computer S is configured to inform the respective manufactures of the electrical vehicles EV1 about findings of the data analytics to the respective vehicle data VD of the respective electrical vehicle EV1. For instance, the respective manufactures of the electrical vehicles EV1 can use these findings in the maintenance cycles and/or the production process of the respective electrical vehicle EV1.

An advantageous embodiment is that the server computer S is configured to inform the respective manufactures and/or respective operators of the respective EV charge points EVCP1 about findings of the data analytics to the data related to the respective EV charge point EVCP1. For instance, the respective manufactures of the EV charge points EVCP1 can use these findings in the maintenance cycles and/or the production process of the respective EV charge points EVCP1.

An advantageous embodiment is that the EV charge point EVCP1 comprises a display D to view text information and/or graphics about findings of the data analytics to the respective vehicle data VD of the respective electrical vehicle EV1. The driver DR of the electrical vehicle EV1 can see this information directly or immediately on the display D of the EV charge point EVCP1.

An advantageous embodiment is that the server computer S is part of a cloud infrastructure C.

A further aspect of the invention is an electrical vehicle charge point EVCP1 (e.g. an EV charging station or a wall box) in communication with a server computer S and a database DB, the EV charge point EVCP1 comprising:
an output (e.g. a cable) to supply electric charging power to an electric vehicle EV1, the electric charging power being provided by an electricity supply unit ESU (e.g. battery, energy provider);
an interface (data interface) to get vehicle data VD out of the electrical vehicle EV1;
a communication link CC1 (radio, IP-communication, etc) to communicate the vehicle data VD to a server computer S;
wherein the EV charge point EVCP1 is configured to receive data about findings of the data analytics to the respective vehicle data VD from the server computer S;
wherein the EV charge point EVCP1 comprises a display D to view text information and/or graphics about the findings of the data analytics to the respective vehicle data VD of the respective electrical vehicle EV1.

Advantageously the output (e.g. a cable) to supply electric charging power to the electric vehicle EV1 and the interface (data interface) to get vehicle data VD out of the electrical vehicle EV1 are integrated (e.g. a cable comprising power line and data line).

An advantageous embodiment is that the EV charge point EVCP1 is configured to view the text information and/or the graphics about the findings of the data analytics during the charging process or immediately after finishing the charging process for the electric vehicle EV1.

An advantageous embodiment is that the EV charge point EVCP1 comprises a data interface to communicate the findings of the data analytics to the respective electrical vehicle EV1 (e.g. via a cable comprising power line and data line).

An advantageous embodiment is that the EV charge point EVCP1 comprises a data interface to communicate the findings of the data analytics to a mobile communication device MG (e.g. smartphone) of the respective driver DR of the electrical vehicle EV1. E.g via Bluetooth pairing or near field communication (NFC).

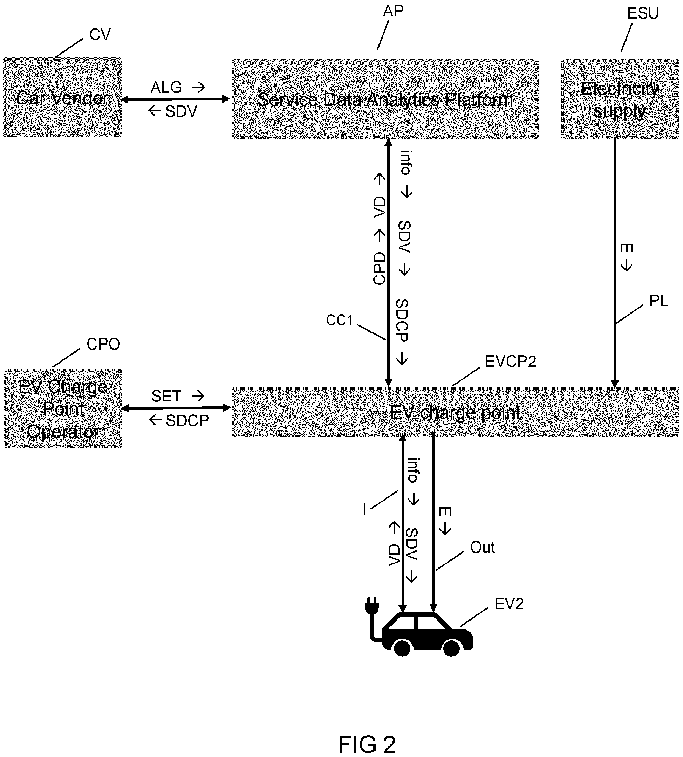

Figure 2 illustrates a second exemplary system for managing electric vehicle EV2 charging and servicing at an EV charge point EVCP2.

The system as illustrated in figure 2 comprises a Service Data Analytics Platform AP which is in communication with the EV charge point EVCP2.

The EV charge point EVCP2 comprises:
an output Out (e.g. a plug connector) to supply electric charging power E to an electric vehicle EV2, the electric charging power E being provided by an electricity supply unit ESU (e.g. power plant of an energy provider);
an interface I (data interface, advantageously integrated into the plug connector) to get vehicle data VD out of the electrical vehicle EV2;
a communication link CC1 (e.g. radio connection) to communicate the vehicle data VD to the Service Data Analytics Platform AP;
wherein the Service Data Analytics Platform AP comprises a server computer (S; Figure 1) configured to receive the vehicle data VD, wherein the server computer (S; Figure 1) is further configured to carry out automated inspections by applying advanced automatic data analytics to the vehicle data VD to evaluate conditions of the electric vehicle EV2 or of critical components of the electric vehicle EV2 during the charging process for the electric vehicle EV2, especially simultaneously or in parallel to the charging process for the electric vehicle EV2.

The electric charging power E is provided by the electricity supply unit ESU (e.g. power plant of an energy provider) to the EV charge point EVCP2 by a powerline PL.

Via the communication link CC1 (e.g. radio connection) the vehicle data VD and/or Charge Point Data CPD are communicated from the EV charge point EVCP2 to the Service Data Analytics Platform AP. The Service Data Analytics Platform AP comprises a server computer (S; Figure 1) configured to receive the vehicle data VD and/or Charge Point Data CPD (e.g. number of charging cycles performed by the EV charge point EVCP2. The server computer (S; Figure 1) is configured to carry out automated inspections by applying advanced automatic data analytics to the vehicle data VD and/or to the Charge Point Data CPD to evaluate conditions of the electric vehicle EV2 or of critical components of the electric vehicle EV2, or of the EV charge point EVCP2 during the charging process for the electric vehicle EV2, especially simultaneously or in parallel to the charging process for the electric vehicle EV2. Advantageously the Service Data Analytics Platform AP is configured as an Ecosystem Service Data Analytics Platform providing analysis services to a plurality of EV charge points EVCP2 and/or to a plurality of electric vehicles EV2. The analysis services can be provided as Software as a Service (SaaS). Each user (e.g. driver, car owner) subscribed at the Service Data Analytics Platform AP can use the analytics services.

By participating in an Ecosystem Service Data Analytics Platform AP, companies can create superior value in the form of products or services with their cooperation partners and/ customers. Furthermore, ecosystems enable companies or stakeholders to enter new markets or to gain competitive advantages over traditional competitors in markets they already represent. An Ecosystem Service Data Analytics Platform AP for EV charge points EVCP2 and/or for electric vehicles EV2 can increase the satisfaction of the customers and therefore increase the loyalty of the customers.

Advantageously also car vendors CV or manufacturers of electrical vehicles EV2 participate in the Ecosystem Service Data Analytics Platform AP. The car vendors CV or the EV manufactures provide the data analytics algorithms ALG and/or test data to carry out automated inspections for the respective electric vehicles EV2 in the Ecosystem Service Data Analytics Platform AP.

The findings and results SDV (Service Data Vehicle) of the automated inspections performed in the Ecosystem Service Data Analytics Platform AP during the charging process for the respective electric vehicle EV2 are provided for car vendors CV or manufacturers of electrical vehicles. For instance, the Service Data Vehicle SDV can be used by the manufacturers of the electrical vehicles EV2 to optimize or to improve the electrical vehicles EV2.

Advantageously also EV Charge Point Operators CPO or manufacturers of EV Charge Points EVCP2 participate in the Ecosystem Service Data Analytics Platform AP. The Ecosystem Service Data Analytics Platform AP can also analyze Charge Point Data CPD (e.g. performance/efficiency data or characteristics of the charging equipment of the EV Charge Point EVCP2) which are provided during the charging process to the server computer of the Ecosystem Service Data Analytics Platform AP.

The findings and results SDCP (Service Data Charge Point) of the automated inspections performed in the Ecosystem Service Data Analytics Platform AP during the charging process for the respective electric vehicle EV2 are provided for EV Charge Point Operators CPO or manufacturers of EV Charge Points EVCP2. The EV Charge Point Operator CPO can adjust the settings SET of the EV Charge Point EVCP2 based on these findings and results SDCP.

Via the interface I (suitable data interface, e.g. cable plug connection) the vehicle data VD are communicated from the electrical vehicle EV2 to the EV charge point EVCP2. Via the communication link CC1 (e.g. radio connection) the vehicle data VD are communicated from the EV charge point EVCP2 to the Service Data Analytics Platform AP.

The Service Data Analytics Platform AP comprises a server computer (S; Figure 1) configured to receive the vehicle data VD (e.g. number of charging cycles performed by the EV charge point EVCP2. The server computer (S; Figure 1) is configured to carry out automated inspections by applying advanced automatic data analytics to the vehicle data VD to evaluate conditions of the electric vehicle EV2 or of critical components of the electric vehicle EV2 during the charging process for the electric vehicle EV2, especially simultaneously or in parallel to the charging process for the electric vehicle EV2.

Information inf, findings and results SDV (Service Data Vehicle) of the automated inspections are provided to the EV charge point EVCP2. Advantageously the EV charge point EVCP2 comprises output means (e.g. display) to show these data to the car driver.

Advantageously Information inf, findings and results SDV (Service Data Vehicle) of the automated inspections are also transferred to the electric vehicle EV2 via the data interface I (e.g. data cable). In the electric vehicle EV2 these data can be used for maintenance services.

The underlying invention provides especially following advantages:
- Carry out regular, advanced inspections of the electric vehicles without visiting the a (manufacturers) service
- point (garage).
- Provide early maintenance recommendations to avoid occurrence of failures by applying automatic analysis,
- predictions and benchmarks.
- Increase quality and performance of Electrical Vehicles.
- Fast release/availability of service offerings and applications to drivers/cars.
- Decrease maintenance cost of Electrical Vehicles, from reactive services to proactive services.
- Gain efficiency for EV owners to analyze the car while they are charging the car instead of visiting a EV Service point (garage).
- Share high value information about quality and conditions of critical component in Electrical Vehicles e.g. batteries with stakeholders such as Car OEMSs/vendors, 3rd party suppliers, etc.
- Secure data connectivity between vehicle and analytics engine (on platform).
- High computing power for advanced analytics available on platform (outside car) which reduces cost.
- Data analytics to realize condition base or predictive maintenance to avoid reactive maintenance.
- Open data protocol for standardized interface /data exchange between cars and chargers.

### Exemplary scenario to use the invention:

The EV charging infrastructure (charge points) is connected to an Advanced Service Data Analytics Platform (incl. analytics engine). This platform will be open to Car OEMs/vendors to deploy vendor specific services, e.g ., diagnostic analytics.

The electric vehicles are accessible (secure data connection) during the charging process, i.e. being connected to the charge point.
i. Get all the (raw) data out of the Electrical Vehicle (EV).
ii. Carry out automated inspections by applying advanced automatic data analytics to evaluate condition of the EV and critical components, conduct system.
iii. inform Electrical Vehicle owners about quality and conditions of the Electric Vehicle.
iv. Translate finding into clear recommendations to the Electric Vehicle owner. E.g. advice to visit a service provider soon to replace/repair the battery.
v. Benchmark the analyses of critical component in Electrical Vehicles from different Car OEMSs/vendors to rank quality, e.g. batteries.
vi. inform Car OEMSs/vendors and other stakeholders about quality and condition analyses.
vii. Provide additional service, deploy applications, remote updates etc.

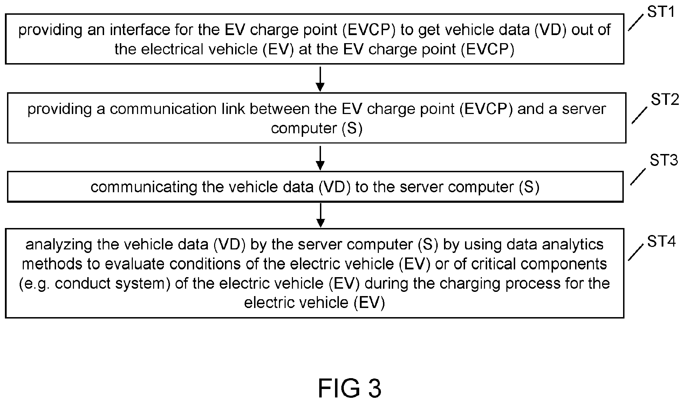

Figure 3 illustrates an exemplary flowchart of a method for checking conditions of an electric vehicle at an EV charge point. The method comprises the following steps:
(ST1) providing an interface for the EV charge point to get vehicle data out of the electrical vehicle at the EV charge point;
(ST2) providing a communication link between the EV charge point and a server computer;
(ST3) communicating the vehicle data to the server computer;
(ST4) analyzing the vehicle data by the server computer by using data analytics methods to evaluate conditions of the electric vehicle or of critical components (e.g. conduct system) of the electric vehicle during the charging process for the electric vehicle.

Advantageously step the step (ST4) is performed simultaneously or in parallel during the charging process for the electric vehicle.

Advantageously the server computer is configured to send information to the owner or driver of the electrical vehicle (EV) about findings of the analysis of the vehicle data.

Advantageously the server computer is configured to send information to the manufacturer of the electrical vehicle about findings of the analysis of the vehicle data.

The server computer is configured to receive the vehicle data, wherein the server computer is further configured to carry out automated inspections by applying data analytics methods to the vehicle data VD to evaluate conditions of the electric vehicle EV1 or of critical components (e.g. conduct system, battery) of the electric vehicle during the charging process for the electric vehicle.

For instance, the server computer comprises an analytics Engine to perform data analytics methods (AI, Artificial Intelligence algorithms) and/or automated inspections to the vehicle data to evaluate conditions of the electric vehicle and/or of critical components (e.g. conduct system, battery, electricity) of the electric vehicle. The server computer comprises suitable Hardware, Software and communication means to receive the vehicle data, to analyze the vehicle data and to provide the results or findings of the analysis of the vehicle data for the EV charge point and/or for a mobile communication device (e.g. smartphone) of the driver or owner of the electric vehicle. Advantageously the EV manufactures provide the data analytics algorithms and/or test data to carry out automated inspections for the respective electric vehicles.

The vehicle data comprise data or a subset of data of the critical components of the electric vehicle: e.g. conduct system, battery (traction battery), electric motor, power electronics, cooling systems, temperature management, heating/air conditioning system, battery management system, thermal management system of battery, powertrain, drive.

Advantageously the vehicle data comprise data recorded in a storage medium of the electric vehicle since the last service date (e.g. last maintenance or service check in a service station (e.g. garage)).

The vehicle data especially comprise data gained during the current charging process. E.g. the respective charging currents, respective charging voltage, respective temperature curves of the battery cells recorded over the entire charging process.

Advantageously during the charging process each battery cell is monitored and the vehicle data VD comprise voltage, currents and temperatures of the cells.

Advantageously during the charging process the temperature of the battery cells, the charging current or currents and the respective charging voltages are monitored to gain vehicle data VD. Since the battery must be cooled during charging, the associated fan should also be monitored to gain vehicle data VD.

The charging voltage could be monitored for small voltage dips when one of the cells connected in series shorts out. The same if the charging resistance suddenly increases, i.e. the charging voltage has to rise abruptly to restore the charging current. If the resistance increases excessively during charging, this may indicate damage inside the battery.

The analytics engine of the server computer can be a rule based engine configured to execute discrete logic or algorithms. The analytics engine could also be a machine learning system comprising suitable neuronal networks.

Advantageously the analytics engine AE has access to suitable historical data, stored e.g. in a database, to perform the checks or inspections based on the vehicle data.

The information info provided by the analytics engine of the server computer can be for instance, notes or hints on upcoming maintenance/service dates.

Data communication to perform the method steps is accomplished bey suitable communication links.

Further advantageous embodiments are a system and a method for checking conditions of an electric vehicle (EV) at an EV charge point, wherein at the EV charge point vehicle data are pulled out of the electrical vehicle (EV) via a suitable interface; wherein the vehicle data are communicated via a communication link from the EV charge point to a server computer; wherein the vehicle data are analyzed by the server computer by using data analytics methods to evaluate conditions of the electric vehicle (EV) or of critical components (e.g. conduct system) of the electric vehicle (EV) during the charging process for the electric vehicle (EV), especially simultaneously during the charging process for the electric vehicle (EV).

### Reference Signs

- EV1, EV2: Electric Vehicle
- EVCP1, EVCP2: EV charge point
- S: server computer
- DB: Database
- AE: Analytics Engine
- C: Cloud
- VD: Vehicle Data
- D: Display
- MG: Mobile Communication Device
- DR: Driver
- SDV: Service Data Vehicle
- SDCP: Service Data Charge Point
- info: Information
- CC1 - CC3: Communication Connection
- ESU: Electricity Supply Unit
- AP: Analytics Platform
- E: Electricity
- SET: Settings
- CPO: Charge Point Operator
- CPD: Charge Point Data
- CV: Car Vendor
- ALG: Analysis Algorithms
- Out: Output
- PL: Powerline
- I: interface
- ST1 - ST4: Step

## Claims

1. A system for managing electric vehicle (EV1, EV2) charging and servicing, the system comprising:
an EV charge point (EVPC1, EVCP2) in communication with a server computer (S) and a database (DB), the EV charge point (EVCP1, EVCP2) comprising:
an output to supply electric charging power to an electric vehicle (EV1, EV2), the electric charging power being provided by an electricity supply unit (ESU);
an interface to get vehicle data (VD) out of the electrical vehicle (EV1, EV2);
a communication link (CC1) to communicate the vehicle data (VD) to the server computer (S);
a server computer (S) configured to receive the vehicle data (VD), wherein the server computer (S) is further configured to carry out automated inspections by applying advanced automatic data analytics to the vehicle data (VD) to evaluate conditions of the electric vehicle (EV1, EV2) or of critical components of the electric vehicle (EV1, EV2) during the charging process for the electric vehicle (EV1, EV2).

2. The system according to claim 1, wherein
the communication link (CC1) is configured to communicate data (CPD) related to the EV charge point (EVCP1, EVCP2) to the server computer (S); and
the server computer (S) is further configured to receive the data (CPD) related to the EV charge point (EVCP1, EVCP2), wherein the server computer (S) is configured to carry out automated inspections by applying advanced automatic data analytics to the data related to the EV charge point (EVCP1, EVCP2) .

3. The system according claim 1 or claim 2, wherein the server computer (S) is part or is integrated in a Service Data Analytics Platform (AP), especially an Ecosystem Service Data Analytics Platform (AP), the Service Data Analytics Platform (AP) providing analysis services to a plurality of EV charge points (EVPC1, EVCP2) and/or to a plurality of electric vehicles (EV1, EV2).

4. The system according to one of the preceding claims, wherein the server computer (S) is configured to inform the respective owners or drivers (DR) of the electrical vehicles (EV1, EV2) about findings (info, SDV) of the data analytics to the respective vehicle data (VD).

5. The system according to one of the preceding claims, wherein the server computer (S) is configured to inform the respective manufactures or venders (CV) of the electrical vehicles (EV1, EV2) about findings of the data analytics to the respective vehicle data (VD).

6. The system according to one of the preceding claims, wherein the server computer (S) is configured to inform the respective manufactures and/or respective operators (CPO) of the respective EV charge points (EVCP1, EVCP2) about findings of the data analytics to the data (CPD) related to the respective EV charge point (EVCP1, EVCP2).

7. The system according to one of the preceding claims, wherein the EV charge point (EVCP1, EVCP2) comprises a display (D) to view text information (info) and/or graphics about findings (SDV) of the data analytics to the respective vehicle data (VD) .

8. The system according to one of the preceding claims, wherein the server computer (S) is part of a cloud infrastructure (C) .

9. An electrical vehicle charge point (EVCP1, EVCP2) in communication with a server computer (S) and a database (DB), the EV charge point (EVCP1, EVCP2) comprising:
an output (Out) to supply electric charging power (E) to an electric vehicle (EV1, EV2), the electric charging power (E) being provided by an electricity supply unit (ESU);
an interface (I) to get vehicle data (VD) out of the electrical vehicle (EV1, EV2);
a communication link (CC1) to communicate the vehicle data (VD) to a server computer (S);
wherein the EV charge point (EVCP1, EVCP2) is configured to receive data about findings (info, SDV) of the data analytics to the respective vehicle data (VD) from the server computer (S);
wherein the EV charge point (EVCP1, EVCP2) comprises a display (D) to view text information (inf) and/or graphics about the findings (SDV) of the data analytics to the respective vehicle data (VD)

10. The EV charge point (EVCP1, EVCP2) according to claim 9, wherein the EV charge point (EVCP1, EVCP2) is configured to view the text information (inf) and/or the graphics about the findings (SDV) of the data analytics immediately after finishing the charging process for the electric vehicle (EV1, EV2).

11. The EV charge point (EVCP) according to claim 9 or to claim 10, comprising a data interface (I) to communicate the findings (SDV) of the data analytics to the respective electrical vehicle (EV).

12. The EV charge point (EVCP) according to one of the claims 9 to claim 11, comprising a data interface (I) to communicate the findings (SDV) of the data analytics (AE) to a mobile communication device (MG) of the respective driver (DR) of the electrical vehicle (EV1, EV2).

13. A method for checking conditions of an electric vehicle (EV1, EV2) at an EV charge point (EVCP1, EVCP2), the method comprising:
(ST1) providing an interface (I) for the EV charge point (EVCP1, EVCP2) to get vehicle data (VD) out of the electrical vehicle (EV1, EV2) at the EV charge point (EVCP1, EVCP2);
(ST2) providing a communication link (CC1) between the EV charge point (EVCP1, EVCP2) and a server computer (S);
(ST3) communicating the vehicle data (VD) to the server computer (S);
(ST4) analyzing the vehicle data (VD) by the server computer (S) by using data analytics methods to evaluate conditions of the electric vehicle (EV1, EV2) or of critical components of the electric vehicle (EV1, EV2) during the charging process for the electric vehicle (EV1, EV2).

14. The method according to claim 13, wherein the server computer (S) is sending information to the owner or driver (DR) of the electrical vehicle (EV1, EV2) about findings (SDV) of the analysis of the vehicle data (VD).

15. The method according to one of the preceding claims 12 or 13, wherein the server computer (S) is sending information to the manufacturer (CV) of the electrical vehicle (EV1, EV2) about findings (SDV) of the analysis of the vehicle data (VD).
